# EUROPEAN PATENT SPECIFICATION

(11) **EP 1 689 218 B1**
(45) Date of publication and mention of the grant of the patent: **17.03.2010**
(21) Application number: 06101081.5
(22) Date of filing: 31.01.2006
(51) Int. Cl.: H05K 5/02

(54) **Frame part of installation casing**
Gestell für ein Einbaugehäuse
Châssis de boîtier pour une installation

(30) Priority: 03.02.2005 FI 20055049
(43) Date of publication of application: 09.08.2006
(73) Proprietor: ABB Oy, 00380 Helsinki (FI)
(72) Inventor: Smalen, Matti, 01800 Klaukkala (FI)
(74) Representative: Holmström, Stefan Mikael

(56) References cited:
- GB-A- 2 401 416
- US-A- 5 808 866
- US-A1- 2003 012 120
- US-B1- 6 272 011

## Description

### FIELD OF THE INVENTION

The present invention relates to a frame part of an installation casing, with the help of which any equipment installed in the installation casing can be protected from external vibration and impacts. In this application, the concept "installation casing" should be understood widely to cover installation casings or cabinets of different type and size, into which components to be protected from vibration can be arranged.

### DESCRIPTION OF THE PRIOR ART

Prior-art solutions exist, in which vibration protection for devices installed in an installation casing is provided by utilizing a layered structure. In such a case, a separate damping layer is arranged between an installation panel and frame plate. The damping layer is made of a material or designed in such a manner that it does not allow external vibration acting on the frame plate to transmit to the devices installed on the installation panel. Such a prior art solution is previously known from GB - A - 2 401 416, for instance. Previously there is also known from US - B - 6 272 011 and US - A - 5 808 866 solutions, where separate springs or vibration isolators are arranged between elements in order to eliminate vibration.

A weakness in the above-mentioned prior-art solution is, however, that it requires that a specific vibration-damping layer, spring or vibration isolator is made and installed in place. This causes extra material costs, manufacturing actions and installation work phases.

### SUMMARY OF THE INVENTION

It is an object of the present invention to provide for use a simpler solution than before, with which devices installed in an installation casing can be protected from external vibration. This object is achieved with the frame part of independent claim 1 and the method of independent claim 6.

For damping vibration, the invention utilizes dents formed in the installation panel or frame plate or both wherein the installation panel and the frame plate are made from metal and the dents are formed by pressing. The number, location, and shape of the dents affect the damping properties so as to provide exactly the right damping for the application.

According to the invention, the installation panel and frame plate comprise an angle, on both sides of which the installation panel and frame plate are fastened to each other through dents. In this way the structure becomes more rigid than before. In addition, one preferred embodiment uses perforation in the area of the dents to provide a structure that enables efficient cooling. In such a case, it is namely possible to provide an airflow in the space between the installation panel and frame plate on both sides of the above-mentioned angle.

Preferred embodiments of the frame part and method of the invention are disclosed in the attached dependent claims 2 to 5 and 7 to 8.

### BRIEF DESCRIPTION OF THE FIGURES

In the following, the invention will be described by way of example in greater detail with reference to the attached figures, in which
Figures 1 and 2 illustrate the assembly of a frame part of the invention, and
Figure 3 shows a preferred embodiment of a frame part of the invention.

### DESCRIPTION OF A FEW EMBODIMENTS

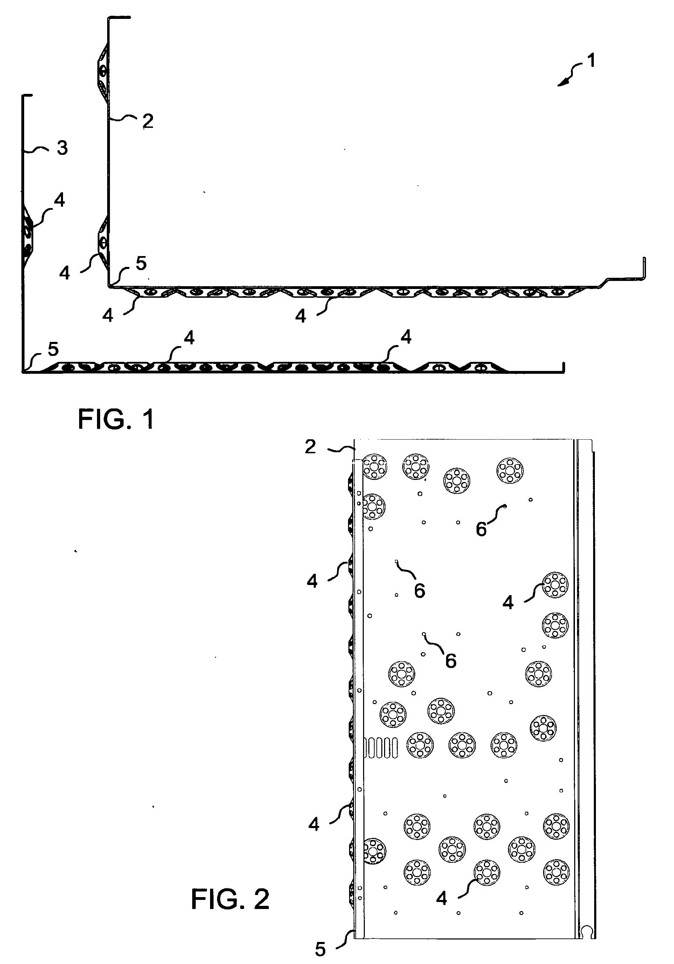

Figures 1 and 2 illustrate the assembly of a frame part of the invention. The frame part 1 is assembled from an installation panel 2 and a frame plate 3. Figure 1 shows the installation panel 2 and frame plate 3 before they are attached to each other, and Figure 2 shows the side of the installation panel 2 that faces the inside of the installation casing.

The metal installation panel 2 of the frame part 1 is made of an even plate in such a manner that the areas where dents will be formed are first perforated through the panel. After this, the dents 4 are formed into the panel by pressing. The dents 4 of the installation panel 2 are formed in such a manner that in a finished frame part, they protrude into the space between the installation panel 2 and frame plate 3. Finally, the installation panel 2 is bent to form an angle 5.

The metal frame plate 3 of the frame part 1 is made in the same manner as the installation panel. The dents in the frame plate 3 are formed in such a manner that in a finished frame part, they protrude into the space between the installation panel 2 and frame plate 3.

A finished frame plate 3 and installation panel 2 are set against each other in the position illustrated in Figure 1. After this, the panel and plate are fastened to each other through the dents 4.

The figures show that the dents are mainly conical in shape, i.e. only their ends are flat where they come into contact with the opposite plate. Such dents can be formed in a plate by pressing.

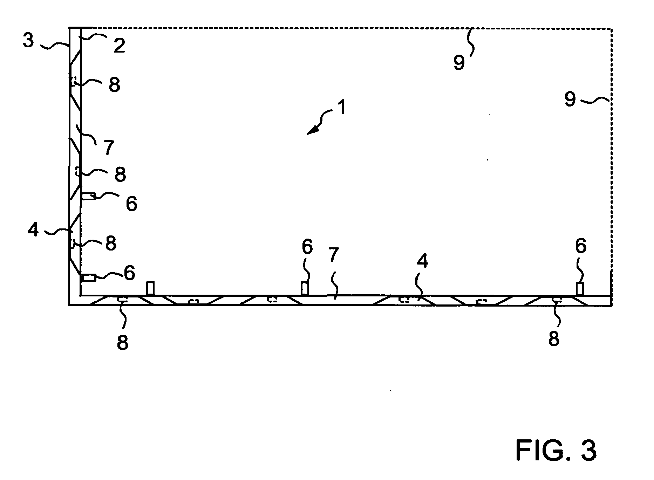

Figure 3 shows a preferred embodiment of a frame part 1 of the invention. In the situation of Figure 3, the frame plate 3 and installation panel 2 are fastened to each other at the dents. The fastening is preferably done by intangible riveting, in which a notch is hit through one of the plates with a sharp object so that the plate material displaced by the sharp object is pressed through the counterpart plate to form a rivet 8 between the plates.

Intangible riveting provides the advantage that the frame part 1 is inexpensive and quick to assemble and that for instance the corrosion risk caused by different material pairs can be avoided, because a separate rivet material is not necessary for the joining. However, the frame plate 3 and installation panel can also be attached to each other in some other manner, for example by screwing, welding, gluing, or by using a separate rivet.

In Figure 3, the frame part 1 is shown installed in place into the installation casing shown from the top. The frame part 1 and the attached plates 9 thus form the walls of the installation casing that enclose the devices to be installed into the installation casing. The device to be installed are fastened to fastening pins 6 protruding from the installation panel 2. The frame plate 3 is fastened to the surrounding structure in such a manner, for instance, that it stands on the base of the installation casing. Because the installation panel 2 is fastened to the frame plate 3 through dents 4 only, vibration protection is achieved with the dents for the devices fastened to the fastening points 6. The efficiency of the vibration protection depends on the shape and perforation of the dents and the thickness of the used plate.

In the example of Figure 3, the dents 4 are staggered on the installation panel 2 and frame plate 3. An alternative is that the dents in the installation panel 2 and frame plate 3 are at the same locations, whereby the dents of different plates settle opposite each other in contact with each other. The distance between the installation panel 2 and frame plate 3 then doubles, and the space 7 becomes wider. This affects the vibration damping properties of the frame part 1 and the volume of air fitting into the space 7.

In Figures 1 and 2, the dents 4 are perforated. This is especially advantageous when devices requiring cooling are installed in the installation casing in question. The installation casing of a frequency converter is one example of a case in which efficient cooling is desirable. A fan can then be installed into the installation casing to provide airflow therein. The air can then flow through the perforations in the dents to the space 7 and out of the installation casing. In such a structure, the frame plate 3 forms the cooling element. By changing the size and location of the perforations, it is possible to affect the airflow. If necessary, filter material, for instance, can be mounted between the installation panel 2 and frame plate 3 during manufacturing, if the propagation of particles flowing in the airflow is to be restricted.

According to the invention, it is also possible that the dents are not perforated, if tightness, for instance, is more important in the application than efficient ventilation.

The figures show that there is an angle 5 in the installation panel 2 and frame plate 3 belonging to the frame part. This angle stiffens the frame part 1. In addition, it is advantageous for ventilation, because air ducts can then be made in the finished installation casing on two walls, i.e. on the leftmost wall and in the bottom wall in Figure 3.

The embodiment shown by way of example in the figures thus makes it possible to provide efficient vibration damping and ventilation (cooling). In several applications, sufficient vibration damping can be achieved with the dents only, and other vibration damping structures are not necessary. According to the invention, it is, however, also possible to have another vibration damping structure in addition to the dents.

It is to be understood that the above description and the related figures are only intended to illustrate the present invention. Various variations and modifications of the invention will be apparent to a person skilled in the art without departing from the scope of protection of the invention.

## Claims

1. A frame part (1) of an installation casing, comprising:
an installation panel (2) for receiving devices to be installed, and
a frame plate (3), and in which
the installation panel (2) and/or the frame plate (3) comprises dents (4) which protrude into a space (7) between the installation panel (2) and frame plate (3) and which are utilized for damping vibrations, the installation panel (2) and frame plate (3) are fastened to each other at the dents, the installation panel (2) and frame plate (3) both comprise an angle (5),
the dents (4) are arranged on both sides of the angle (5) of the installation panel and/or frame plate, and
the dents fastening the installation panel (2) and frame plate (3) to each other are located on both sides of the angle of the installation panel and of the frame plate **characterized in that** the installation panel (2) and the frame plate (3) are made from metal and the dents (4) are formed into the installation panel (2) and the frame plate (3) by pressing.

2. A frame part as claimed in claim 1, **characterised in that** the installation panel (2) and frame plate (3) are fastened to each other with a rivet (8) consisting of material of the installation panel (2) or frame plate (3) which has been pressed through the other one of the installation panel (2) or frame plate (3) with a sharp object.

3. A frame part as claimed in claim 1 or 2, **characterised in that** at least part of the area of the dents (4) is perforated.

4. A frame part as claimed in any one of claims 1 to 3, **characterised in that**
the installation panel (2) and frame plate (3) have dents settling against each other, and
the installation panel (2) and frame plate (3) are fastened to each other at the dents (4) that settle against each other.

5. A frame part as claimed in any one of claims 1 to 4, **characterised in that** the dents (4) are mainly conical in shape.

6. A method for manufacturing a frame part (1) of an installation casing, the method comprising
taking into use an installation panel (2) and a frame plate (3),
selecting for shaping the installation panel (2) or frame plate (3), or alternately both the installation panel (2) and the frame plate (3), to form dents (4) for damping vibrations at predetermined locations in the selected plate,
setting the installation panel (2) and frame plate (3) to face each other in such a manner that the dents (4) protrude into the space (7) between the installation panel (2) and frame plate (3), fastening the installation panel (2) and frame plate (3) to each other at the dents (4), and bending the installation panel (2) and frame plate (3) before they are set to face each other, to form an angle (5) in both the installation panel (2) and frame plate (3) so that the dents (4) fastening the installation panel (2) and frame plate (3) to each other are located on both sides of the angle (5) of the installation panel (2) and of the frame plate (3), **characterized in that**
an installation panel (2) and a frame plate (3) of metal is taken into use, and
said dents (4) are formed into the installation panel (2) and the frame plate (3) by pressing.

7. A method as claimed in claim 6, **characterised in that** during the shaping, perforations are formed in the areas where the dents are made (4).

8. A method as claimed in claim 6 or 7, **characterised by** fasting the installation panel (2) and frame plate (3) to each other at the dents by pressing material of the installation panel (2) or frame plate (3) through the other one of the installation panel (2) or frame plate (3) with a sharp object in order to form a rivet (8).

## Patentansprüche

1. Rahmenteil (1) für ein Einbaugehäuse mit:
einer Einbauplatte (2) zum Aufnehmen von einzubauenden Geräten und
einer Rahmenplatte (3), in dem
die Einbauplatte (2) und/oder die Rahmenplatte (3) Einbeulungen (4) aufweisen, die in einen Raum (7) zwischen der Einbauplatte (2) und der Rahmenplatte (3) hineinragen und die zur Dämpfung von Schwingungen eingesetzt werden, die Einbauplatte (2) und die Rahmenplatte (3) an den Einbeulungen aneinander befestigt werden, die Einbauplatte (2) und die Rahmenplatte (3) beide einen Winkel (5) aufweisen,
die Einbeulungen (4) auf beiden Seiten des Winkels (5) der Einbauplatte und/oder der Rahmenplatte angeordnet sind und
die die Einbauplatte (2) und die Rahmenplatte (3) aneinander befestigenden Einbeulungen sich auf beiden Seiten des Winkels der Einbauplatte und der Rahmenplatte befinden, **dadurch gekennzeichnet, dass** die Einbauplatte (2) und die Rahmenplatte (3) aus Metall hergestellt sind und die Einbeulungen (4) in der Einbauplatte (2) und der Rahmenplatte (3) durch Pressung gebildet werden.

2. Rahmenteil nach Anspruch 1, **dadurch gekennzeichnet, dass** die Einbauplatte (2) und die Rahmenplatte (3) mit einer aus dem Material der Einbauplatte (2) und der Rahmenplatte (3) hergestellten Nietung (8) aneinander befestigt werden, die durch die eine der Einbauplatte (2) oder der Rahmenplatte (3) mit einem scharfen Gegenstand gepresst worden ist.

3. Rahmenteil nach Anspruch 1 oder 2, **dadurch gekennzeichnet, dass** zumindest ein Teil des Bereichs der Einbeulungen (4) perforiert ist.

4. Rahmenteil nach einem der Ansprüche 1 bis 3, **dadurch gekennzeichnet, dass**
die Einbauplatte (2) und die Rahmenplatte (3) Einbeulungen aufweisen, die sich gegeneinander stellen und
die Einbauplatte (2) und die Rahmenplatte (3) an den Einbeulungen (4) aneinander befestigt werden, die sich gegeneinander stellen.

5. Rahmenteil nach einem der Ansprüche 1 bis 4, **dadurch gekennzeichnet, dass** die Einbeulungen (4) hauptsächlich eine kegelförmige Form aufweisen.

6. Verfahren zur Herstellung eines Rahmenteils (1) für ein Einbaugehäuse, aufweisend:
Bringen einer Einbauplatte (2) und einer Rahmenplatte (3) zur Anwendung,
Auswählen der Einbauplatte (2) oder der Rahmenplatte (3) oder alternativ sowohl der Einbauplatte (2) als auch der Rahmenplatte (3) für Verformung, um Einbeulungen zur Dämpfung von Schwingungen an vorbestimmten Stellen in der ausgewählten Platte zu bilden,
Anstellen der Einbauplatte (2) und der Rahmenplatte (3) einander gegenüberliegend, so dass die Einbeulungen (4) in den Raum (7) zwischen der Einbauplatte (2) und der Rahmenplatte (3) hineinragen, wobei sie die Einbauplatte (2) und die Rahmenplatte (3) an den Einbeulungen (4) aneinander befestigen, und Biegen der Einbauplatte (2) und der Rahmenplatte (3), bevor sie einander gegenüberliegend angestellt werden, um einen Winkel (5) sowohl in der Einbauplatte (2) als auch in der Rahmenplatte (3) auszubilden, so dass sich die die Einbauplatte (2) und die Rahmenplatte (3) aneinander befestigenden Einbeulungen (4) auf beiden Seiten des Winkels (5) der Einbauplatte (2) und der Rahmenplatte (3) befinden, **gekennzeichnet durch**
Bringen einer Einbauplatte (2) und einer Rahmenplatte (3) aus Metall zur Anwendung und
Bilden der besagten Einbeulungen (4) in der Einbauplatte (2) und der Rahmenplatte (3) **durch** Pressung.

7. Verfahren nach Anspruch 6, **dadurch gekennzeichnet, dass** während der Verformung Perforierungen in den Bereichen ausgebildet werden, wo die Einbeulungen (4) hergestellt werden.

8. Verfahren nach Anspruch 6 oder 7, **gekennzeichnet durch** Befestigung der Einbauplatte (2) und der Rahmenplatte (3) aneinander an den Einbeulungen, indem Material der Einbauplatte (2) oder der Rahmenplatte (3) **durch** die eine der Einbauplatte (2) oder der Rahmenplatte (3) mit einem scharfen Gegenstand gepresst wird, um eine Nietung (8) herzustellen.

## Revendications

1. Châssis d'un boîtier d'installation (1), comprenant
un panneau d'installation (2) pour recevoir des dispositifs devant être installés, et une plaque de châssis (3), et dans laquelle
le panneau d'installation (2) et/ou la plaque de châssis (3) comprend des bossages (4) qui font saillie dans un espace (7) entre le panneau d'installation (2) et la plaque de châssis et qui sont utilisés pour amortir les vibrations, le panneau d'installation (2) et la plaque de châssis (3) sont fixés l'un à l'autre au niveau des bossages, le panneau d'installation (2) et la plaque de châssis (3) comprennent tous les deux un angle (5),
les bossages (4) sont agencés de chaque côté de l'angle (5) du panneau d'installation et/ou de la plaque de châssis, et
les bossages (4) fixant le panneau d'installation (2) et la plaque de châssis (3) l'un à l'autre sont situés de chaque côté de l'angle du panneau d'installation et de la plaque de châssis, **caractérisé en ce que** le panneau d'installation (2) et la plaque de châssis (3) sont faits en métal et les bossages (4) sont formés dans le panneau d'installation (2) et la plaque de châssis (3) par pressage/moulage.

2. Châssis selon la revendication 1, **caractérisé en ce que** le panneau d'installation (2) et la plaque de châssis (3) sont fixés l'un à l'autre avec un rivet (8) composé du matériau du panneau d'installation (2) ou de la plaque de châssis (3) qui a été pressé/moulé au travers de l'autre panneau d'installation (2) ou plaque de châssis (3) avec un objet pointu.

3. Châssis selon la revendication 1 ou 2, **caractérisé en ce qu'**au moins une partie de la zone des bossages (4) est perforée.

4. Châssis selon l'une quelconque des revendications 1 à 3, **caractérisé en ce que**
le panneau d'installation (2) et la plaque de châssis (3) ont des bossages s'adaptant les uns contre les autres, et
le panneau d'installation (2) et la plaque de châssis (3) sont fixés l'un à l'autre au niveau des bossages (4) qui s'adaptent les uns contre les autres.

5. Châssis selon l'une quelconque des revendications 1 à 4, **caractérisé en ce que** les bossages (4) sont principalement de forme conique.

6. Procédé de fabrication d'une châssis (1) d'un boîtier d'installation, le procédé comprenant les étapes consistant à :
utiliser un panneau d'installation (2) et une plaque de châssis (3),
sélectionner pour façonnage le panneau d'installation (2) ou la plaque de châssis (3), ou de façon alternative, à la fois le panneau d'installation (2) et la plaque de châssis (3), pour former des bossages (4) pour amortir des vibrations à des emplacements déterminés dans la plaque sélectionnée,
placer le panneau d'installation (2) et la plaque de châssis (3) l'un face à l'autre de manière à ce que les bossages (4) fassent saillie dans l'espace (7) entre le panneau d'installation (2) et la plaque de châssis (3), fixant le panneau d'installation (2) et la plaque de châssis (3) l'un à l'autre au niveau des bossages (4), et pliant le panneau d'installation (2) et la plaque de châssis (3) avant qu'ils soient placés l'un face à l'autre, pour former un angle (5) à la fois dans le panneau d'installation (2) et dans la plaque de châssis (3) de manière à ce que les bossages (4) fixant le panneau d'installation (2) et la plaque de châssis (3) l'un à l'autre soient situés de chaque côté de l'angle (5) du panneau d'installation (2) et de la plaque de châssis (3), **caractérisé en ce que**
on utilise un panneau d'installation (2) et une plaque de châssis (3) en métal, et
lesdits bossages (4) sont formés dans le panneau d'installation (2) et la plaque de châssis (3) par pressage/moulage.

7. Procédé selon la revendication 6, **caractérisé en ce que** pendant le façonnage, des perforations sont formées dans les zones où les bossages sont faits (4).

8. Procédé selon la revendication 6 ou 7, **caractérisé par** l'étape consistant à fixer le panneau d'installation (2) et la plaque de châssis (3) l'un à l'autre au niveau des bossages en pressant/moulant le matériau du panneau d'installation (2) et de la plaque de châssis (3) avec un objet pointu afin de former un rivet (8).
